Europäisches Patentamt

European Patent Office

Office européen des brevets

(11) Veröffentlichungsnummer : **0 187 882
B1**

(12) **EUROPÄISCHE PATENTSCHRIFT**

(45) Veröffentlichungstag der Patentschrift :
05.04.89

(21) Anmeldenummer : 85100403.6

(22) Anmeldetag : 17.01.85

(51) Int. Cl.⁴ : **C 23 F   4/00, H 01 L  21/285//
C23C14/02**

(54) **Verfahren zur Herstellung von Kontakten mit niedrigem Übergangswiderstand.**

(43) Veröffentlichungstag der Anmeldung :
23.07.86 Patentblatt 86/30

(45) Bekanntmachung des Hinweises auf die Patenterteilung : 05.04.89 Patentblatt 89/14

(84) Benannte Vertragsstaaten :
**DE FR GB**

(56) Entgegenhaltungen :
US-A- 3 839 177
US-A- 4 372 806
PATENTS ABSTRACTS OF JAPAN, Band 8, Nr. 184
(C-239) [1621], 23. August 1984; & JP - A - 59 76 874
(MATSUSHITA DENKI SANGYO K.K.) 02-05-1984
JOURNAL OF ELECTROCHEMICAL SOCIETY: SOLID
STATE SCIENCE, Band 116, Nr. 1, Januar 1969,
Seiten 100-103, New York, US; P.D. DAVIDSE: "RF
sputter etching-a universal etch"
JAPANESE JOURNAL OF APPLIED PHYSICS, Band 9,
Nr. 2, Februar 1970, Seiten 174-181, Tata Institute of
Fundamental Research, Bombay, India; R. PINTO
u.a.: "Getter-bias sputtering of high purity metal films
in a high current vacuum discharge in the 10-4 torr
range"
THIN SOLID FILMS, Band 54, 1978, Seiten 345-351,
Elsevier Sequoia, Amsterdam, NL; D. HÜBNER u.a.:
"Metallization of semiconductor devices by high rate
sputtering of aluminum"
IBM TECHNICAL DISCLOSURE BULLETIN, Band 20,
Nr. 2, Juli 1977, Seiten 574-575, New York, US; H.J.
BAUER: "Obtaining an oxide-free interface in via
connections"

(73) Patentinhaber : **IBM DEUTSCHLAND GMBH
Pascalstrasse 100
D-7000 Stuttgart 80 (DE)
DE
International Business Machines Corporation
Old Orchard Road
Armonk, N.Y. 10504 (US)
FR GB**

(72) Erfinder : **Bauer, Hans-Jürgen, Dr.
Landhausstrasse 51
D-7030 Böblingen (DE)**
Erfinder : **Fröhlich, Marianne-Babette
Geleener Strasse 24
D-7030 Böblingen (DE)**

(74) Vertreter : **Kreidler, Eva-Maria, Dr. rer. nat.
Schönaicher Strasse 220
D-7030 Böblingen (DE)**

**Beschreibung**

Die Erfindung betrifft ein Verfahren zur Herstellung von Kontakten mit niedrigem Übergangswiderstand zwischen einer ersten und einer zweiten Metallisierung in integrierten Halbleiterschaltungen, bei dem Halbleitersubstrate in einen Substrathalter einer Vakuumkammer gelegt werden, die Kammer evakuiert und ein Edelgas eingeführt wird und die Substrate im Bereich der Kontaktöffnungen und Kanäle durch Anlegen einer Hochfrequenz an den Substrathalter mittels Kathodenzerstäubung gereinigt werden. Die Erfindung umfaßt auch eine Vorrichtung zur Durchführung des Verfahrens.

In der Halbleitertechnologie ist bei Anwendung von Aluminiummetallisierungen die Herstellung guter Kontaktverbindungen von einer Metallage zur nächsten sehr schwierig, weil sich auf Aluminium, wenn es Luft ausgesetzt wird, wegen seiner großen Affinität zu Sauerstoff eine fest anhaftende, dünne Oxidhaut bildet. Bei Schaltkreisen mit niedriger Schaltkreisdichte und verhältnismäßig wenigen, aber großen Kontaktöffnungen läßt sich dieses Problem in einfacher Weise dadurch lösen, daß die Halbleitersubstrate vor dem Aufbringen der nächsten Metallage mit verdünnter gepufferter Flußsäure geätzt werden. Diese Behandlung bewirkt, daß sich in den Kontaktlöchern eine dünne, nicht zusammenhängende Aluminiumoxidschicht ausbildet. Eine Hitzebehandlung der so vorbereiteten Substrate nach der Metallisierung bei etwa 400 °C bewirkt eine Aluminiumselbstdiffusion und Rekristallisation an der ursprünglichen Grenzfläche von Metall zu Metall in den Kontaktöffnungen. Auf diese Weise wurden brauchbare, niedrige Übergangswiderstände erhalten.

Es wurde vorgeschlagen (IBM-TDB Vol. 19, Nr. 1, 1976, Seite 20), durch Eintauchen von Wafern in eine Zinksalz-Flußsäure-Lösung auf der vorher gereinigten Metalloberfläche einen Zinküberzug zu erzeugen. Die Wafer werden dann auf etwa 200 bis 250 °C erhitzt und das gewünschte Metall abgeschieden. Nach der Metallabscheidung werden die Wafer in inerter Atmosphäre etwa 30 Minuten lang auf etwa 350 °C erhitzt, was zu einer Ausdiffusion von Zinkatomen in benachbarte Metallagen und daraus resultierend zu niedrigen Übergangswiderständen führt.

Es wurde auch vorgeschlagen, eine Zwischenschicht aus Titan zwischen erster und zweiter Metallisierung zu verwenden. Der Titanfilm reduziert das Aluminiumoxid im Bereich des Kontaktlochs und bewirkt dadurch eine Herabsetzung des Übergangswiderstandes zwischen den beiden Leiterzugebenen. Nachteilig an diesem Verfahren ist, daß es schwierig zu überwachen ist, und daß die damit erzielte Herabsetzung des Übergangswiderstandes bei Übergang zu kleinen Kontaktöffnungen (d < 5 µm) nicht mehr ausreichend ist.

Bei integrierten Schaltungen mit hoher Schaltkreisdichte, bei denen der Lochdurchmesser ab- und die Anzahl der Löcher drastisch zunimmt, sind konventionelle Reinigungsverfahren nicht mehr anwendbar. Es bestand daher ein Bedürfnis nach einem effektiven Reinigungsverfahren für Kontaktlöcher. Als solches wurde ein In-situ-Reinigungsverfahren mittels Kathodenzerstäubung entwickelt (IBM-TDB Vol. 20, Nr. 2, 1977, Seiten 574 bis 576).

Nach diesem wird vor dem Aufdampfen der zweiten Metalllage die Oberflächen der ersten Metallage mittels Kathodenzerstäubung, d. h. durch Anlegen einer Hochfrequenzspannung an die Waferhalterung in einer Argonatmosphäre bei niedrigem Druck gereinigt. Die Bedingungen für die Kathodenzerstäubung wurden dabei so gewählt, daß etwa 10 nm Aluminium oder Aluminiumoxid von Aluminiumscheiben, welche auf der Rückseite der Wafer angeordnet sind, entfernt werden.

Bei diesem Verfahren reduziert sich der Übergangswiderstand praktisch auf Null. Die Effektivität des Verfahrens wird besonders deutlich, wenn man Wafer, die in einem Vakuumsystem mittels Kathodenzerstäubung gereinigt und dann vor dem Aufdampfen der nächsten Metallage mehrere Minuten lang Luft ausgesetzt waren, mit Wafern vergleicht, die nach der Reinigung mittels Kathodenzerstäubung ohne unterbrechung des Vakuums mit Metall bedampft wurden. Es kann gezeigt werden, daß unter den erstgenannten Bedingungen Aluminium wieder rasch unter Ausbildung einer Oxidbarriere mit einer Schichtdicke von etwa 1,5 bis 2,0 nm oxidiert. Der In-situ-Reinigungsprozeß mittels Kathodenzerstäubung ohne Unterbrechung des Vakuums ist deshalb für hohe Produktausbeuten besonders günstig.

Dieses Verfahren ist jedoch nicht anwendbar bei Prozessen, bei denen Massen aus temperaturempfindlichen Photoresistmaterialien Anwendung finden, weil der verwendete Resist durch die durch den Ionenbeschuß bedingte starke Erwärmung während der Reinigung teilweise polymerisiert und sich dann nicht mehr vom Substrat ablösen läßt.

Aufgabe der Erfindung ist deshalb die Angabe eines Verfahrens, mit dem auch Halbleitersubstrate, die mit Masken aus temperaturempfindlichen Resistmaterialien bedeckt sind, unter Anwendung der Kathodenzerstäubung gereinigt werden können.

Die Aufgabe der Erfindung wird gelöst durch ein Verfahren der eingangs genannten Art, das dadurch gekennzeichnet ist, daß vor dem Anlegen der Hochfrequenz an den Substrathalter an einer Hilfselektrode, welche aus einem eine Getterwirkung aufweisenden Material besteht und gegen die Wandungen der Kammer elektrisch isoliert ist, ein Gasplasma erzeugt wird.

Vorteilhafte Ausgestaltungen der Erfindung sind in den Unteransprüchen niedergelegt.

Gegenstand der Erfindung ist auch eine Vorrichtung zur Durchführung des Verfahrens nach Anspruch 1.

Die Erfindung wird anhand der speziellen Beschreibung und der Figuren 1 bis 4 näher erläutert.

Fig. 1 ist eine perspektivische Ansicht eines Halbleitersubstrats mit einem Kanal und einer Kontaktöffnung, welche gereinigt werden soll;

Fig. 2 zeigt schematisch den Ablauf eines Photoresistprozesses für die Herstellung einer Lift-off-Maske zur Strukturierung einer Metallage;

Fig. 3 zeigt eine Vorrichtung zur Durchführung des erfindungsgemäßen Verfahrens;

Fig. 4 zeigt eine weitere Vorrichtung zur Durchführung des erfindungsgemäßen Verfahrens.

Unter einem Kontaktloch innerhalb einer Halbleitervorrichtung wird eine kleine Öffnung in einer Isolationsschicht, welche mit Metall gefüllt wird, verstanden. Kontaktlöcher dienen dazu, elektrische Leiterzüge oberhalb und unterhalb der Isolationsschicht miteinander zu verbinden.

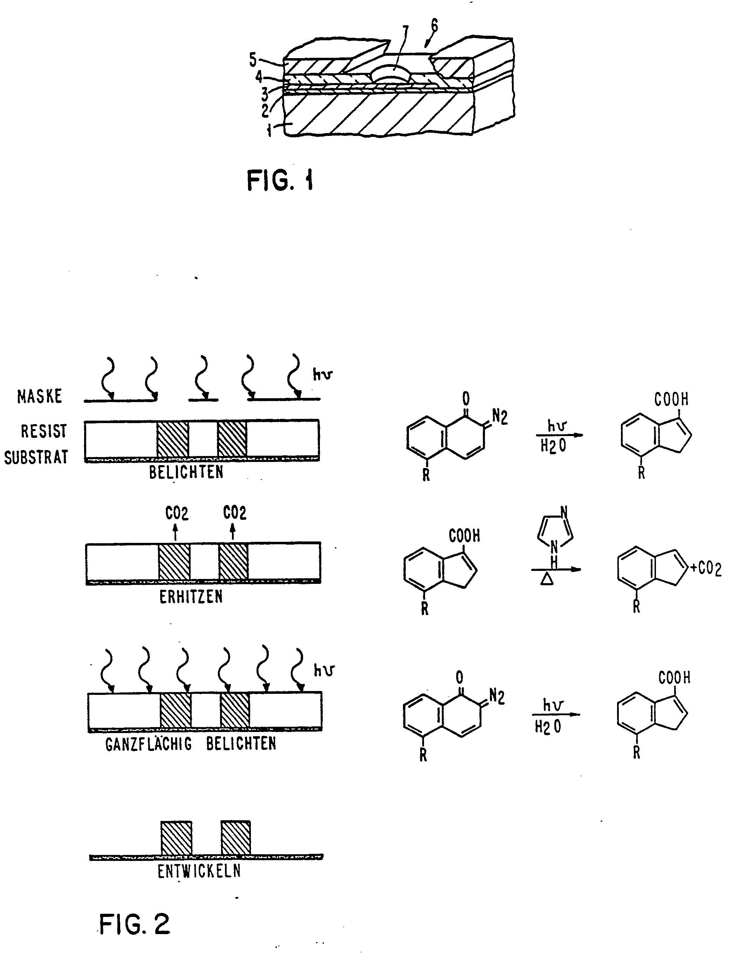

In Fig. 1 ist ein typisches Halbleitersubstrat 1 mit einer unebenen Oberflächentopologie dargestellt. Eine Isolationsschicht 2 ist auf der Oberfläche des Halbleitersubstrats 1 angeordnet. Auf der Isolationsschicht 2 befindet sich eine Metallschicht 3, deren Oberfläche wiederum von einer Isolationsschicht 4 bedeckt ist. Eine Photoresistschicht 5 wird verwendet, um in bekannter Weise Photoresistmuster zu entwickeln. Wie in Fig. 1 gezeigt ist, wurde in der Isolationsschicht 4 eine Kontaktöffnung 7 gebildet. Für die Abscheidung einer zweiten Metallage (nicht gezeigt) ist in der Photoresistschicht 5 ein Kanal 6 freigelegt. Vor dem Aufbringen der zweiten Metallage ist es erforderlich, die Oberfläche der Isolationsschicht 4 im Bereich des Kanals 6 und die Oberfläche der Metallschicht 3 im Bereich der Kontaktöffnung 7 zu reinigen.

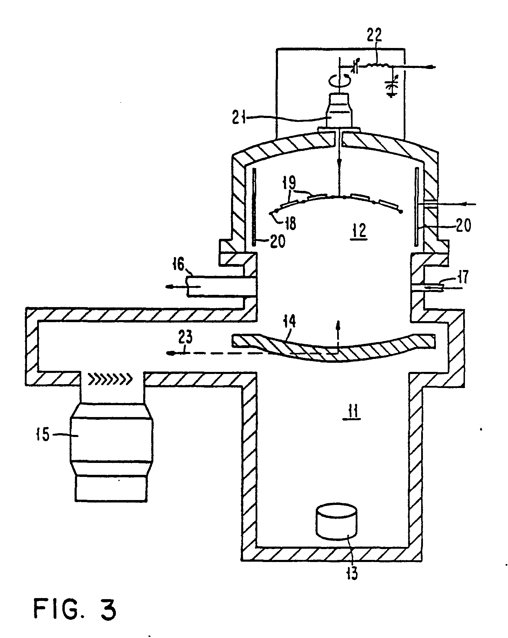

Eine zur Reinigung verwendete Vorrichtung, welche die Prinzipien der Erfindung anwendet, und in der auch die zweite Metallage aufgedampft wird, ist schematisch in Fig. 3 dargestellt. Sie umfaßt eine Kathodenzerstäubungsanlage für die In-situ-Reinigung von Oberflächen, insbesondere von Halbleiteroberflächen mit Kanälen und Kontaktöffnungen. In derselben Vorrichtung kann unter Beibehaltung des Vakuums ein Metall, beispielsweise Aluminium oder Aluminiumkupfer, aufgedampft werden. Im einzelnen sind eine Arbeitskammer 12 und eine Verdampfungskammer 11 mit einer Quelle 13 vorgesehen, wobei zwischen beiden Kammern ein Schieber 14 angeordnet ist, mit dem die Arbeitskammer 12 von der Verdampfungskammer 11 abgetrennt werden kann. Über eine Diffusionspumpe 15 wird in den Kammern 11, 12 das während der Verdampfung gewünschte Vakuum eingestellt und aufrechterhalten, während über eine zusätzliche, nicht dargestellte Diffusionspumpe, welche über die Leitung 16 an die Arbeitskammer 12 angeschlossen ist, in der Arbeitskammer das während der Reinigung mittels Kathodenzerstäubung gewünschte Vakuum eingestellt wird. Für die Zuführung eines Gases in diese Kammer, beispielsweise von Argon, ist ein Einlaß 17 vorgesehen. Zur Aufnahme von Siliciumwafern 19 ist in der Kammer 12 ein elektrisch isolierter Substrathalter 18 drehbar angeordnet. Ein Motor bewirkt über eine drehbar gelagerte Hochfrequenzdurchführung 21 die Rotation des Substrathalters 18. Die Hochfrequenzdurchführung 21 dient auch zum Anlegen eines von einem Generator erzeugten Hochfrequenzpotentials an den Substrathalter 18 über ein Anpassungsnetzwerk 22.

Die Kammer 12, die zur Reinigung von Halbleiteroberflächen mittels Kathodenzerstäubung dient, ist zur Durchführung des erfindungsgemäßen Verfahrens zusätzlich mit einer Hilfselektrode 20 aus Aluminium ausgestattet, die gegen die Wandung der Kammer elektrisch isoliert und wie in Fig. 3 dargestellt ist, in einem minimalen Abstand von 3 cm zu dieser ringförmig angeordnet ist. Die Hilfselektrode 20 ist auch, ähnlich wie 18, über ein Netzwerk an eine Wechselstromspannungsquelle, oder, bei Beaufschlagung mit Gleichspannung, direkt an eine Gleichspannungsquelle angeschlossen.

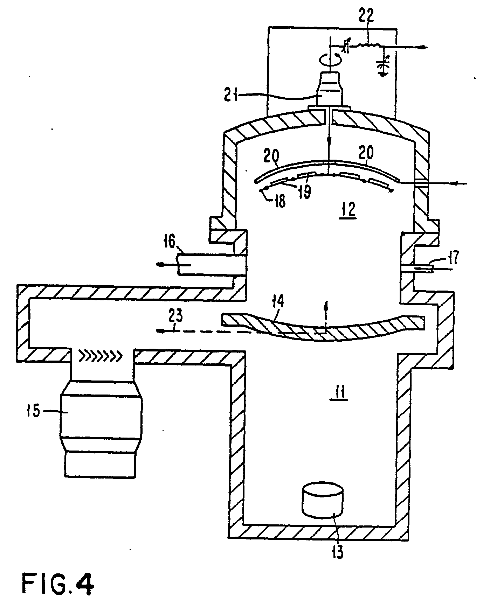

In Fig. 4 ist eine weitere Anordnung der Hilfselektrode 20 dargestellt, bei der diese die Form einer Kugelkalotte besitzt, die mit dem Substrathalter 18 konform ist. Die Kugelkalotte ist ebenfalls wie die ringförmige Hilfselektrode 20 in Fig. 3 aus Aluminium und gegen die Wandung der Kammer elektrisch isoliert. Der elektrische Anschluß der Kugelkalotte an eine Spannungsquelle entspricht der der Hilfselektrode 20 in Fig. 3.

In der zuvor beschriebenen Vorrichtung können, wie in der Aufgabe der Erfindung angegeben ist, Halbleitersubstrate mit Photoresistmasken, insbesondere aus temperaturempfindlichen Resistmaterialien, beispielsweise Wafer mit Masken aus einem modifizierten Resist auf der Basis von Novolak und Chinondiazid oder mit Elektronenstrahlresistmasken, beispielsweise aus Polymethylmethacrylat oder Methylmethacrylat-Methacrylsäureanhydrid-Copolymer mittels Kathodenzerstäubung In-situ gereinigt werden. Ganz allgemein ist das erfindungsgemäße Verfahren und die Vorrichtung zur schonenden Reinigung von Halbleitersubstraten mit Photoresistmasken geeignet.

In einem speziellen Ausführungsbeispiel soll die Reinigung eines Halbleitersubstrats mit einer Photoresistmaske mit negativen Böschungswinkeln (5 in Fig. 1) beschrieben werden. Photoresistmasken mit negativem Böschungswinkel sind besonders vorteilhaft für die Herstellung von Metallisierungsmustern nach dem häufig durchgeführten sog. Lift-off-Verfahren, bei dem zuerst eine Photoresistmaske mit besagten negativen Böschungswinkeln auf dem Substrat erzeugt und dann Metall ganzflächig aufgedampft wird. Das Metall auf der Photoresistmaske wird anschließend zusammen mit dieser abgehoben unter Zurücklassung des gewünschten Metallisierungsmusters auf dem Substrat. Die negativen Böschungswinkel der Photoresistmaske ergeben hierbei in dem Lift-off-Verfahren eine sauber definierte Trennlinie unter Vermeidung einer Ablösung des Metallisierungsmusters von dem Substrat.

Zur Herstellung von Resiststrukturen mit negativen Böschungswinkeln kann das in Fig. 2 schematisch dargestellte Maskenumkehrverfahren, das nachfolgend kurz erläutert werden soll, angewendet werden. Dem in diesem Verfahren verwendeten positiven Resist auf der Basis von Novolakharz und Chinondiazid wird eine kleine Menge eines basischen Additivs wie Imidazol, 1-Hydroxyethyl-2-alkylimidazolin oder Triethanolamin zugesetzt. In dem Umkehrverfahren wird der so modifizierte Resist durch eine Maske belichtet, nach dem bildmäßigen Belichten durch Erhitzen gehärtet, ganzflächig belichtet und schließlich in einer verdünnten wässrigen Lauge entwickelt. Dabei wird ein Negativbild der Maske mit negativen Böschungswinkeln und von hoher Qualität erhalten. Wenn der Resist nur mit UV-Licht belichtet und in wässriger Lauge entwickelt wird, wird ein positives Bild der Maske erhalten. Die Prozeßabfolge des Maskenumkehrverfahrens ist auf der rechten Seite von Fig. 2 formelmäßig dargestellt. Nachteilig ist allerdings, daß Lift-off-Strukturen aus dem modifizierten Photoresist bei etwa 115 °C zu fließen beginnen. Aus diesem Grund konnten bisher In-situ-Reinigungsverfahren mittels Kathodenzerstäubung bei Wafern mit Masken aus dem zuvor beschriebenen Resist nicht angewendet werden, weil bei einer Reinigung der Kontaktöffnungen mittels Kathodenzerstäubung bei einer Dauer von 3 1/2 Minuten im Minimum an der Waferoberfläche Temperaturen bis zu 180 °C auftreten und die Masken zusammenfließen.

Bei der Reinigung nach dem erfindungsgemäßen Verfahren werden die zu reinigenden Wafer 19 (Fig. 3) in den Substrathalter 18 gelegt. Nach dem Abpumpen der Kammer 12 auf einen Druck im Hochvakuumbereich von $< 1,33 \times 10^{-6}$ Millibar und dem Einfüllen von Argongas durch den Einlaß 17 bis zu einem Druck von etwa $1,33 \times 10^{-3}$ bis $1,33 \times 10^{-2}$ Millibar wird zuerst eine Spannung von etwa 600 Volt an die Aluminiumhilfselektrode 20 gelegt und ein Gasplasma erzeugt. Durch das Gasplasma wird Aluminium von der Aluminiumhilfselektrode abgetragen und dadurch der Sauerstoff- und Wasserdampfpartialdruck in der Kammer 2 durch Chemisorption herabgesetzt und das Vakuum in der Kammer verbessert. Nach etwa 5 bis 10 Minuten wird die Spannung von der Aluminiumhilfselektrode abgeschaltet und die Hochfrequenz am Substrathalter 18 eingeschaltet. Es wird mit einer Energiedichte von etwa 0,2 bis 0,3 Watt/cm$^2$ für die Dauer von 1/2 bis 1 Minute gearbeitet. Während dieser Zeit wird die Oberfläche der Isolationsschicht 4 im Bereich des Kanals 6 und die Oberfläche der Metallschicht 3 im Bereich der Kontaktöffnung 7 (Fig. 1) durch Kathodenzerstäubung gereinigt, d. h. Aluminiumoxid wird von der Oberfläche der ersten Metallisierung aus Aluminium oder Aluminiumkupfer im Bereich der Kontaktöffnungen abgetragen. Im Anschluß an die Kathodenzerstäubung wird das Argongas abgepumpt, der Schieber 14 zur Vereinigung der beiden Kammern 11 und 12 in Pfeilrichtung 23 bewegt, und ohne Unterbrechung des Vakuums wird mit dem Aufdampfen der zweiten Aluminium bzw. Aluminiumkupferschicht begonnen. Durch die oben beschriebene Reinigung mittels Kathodenzerstäubung reduziert sich der Widerstandswert zwischen der ersten und zweiten Metallisierung auf den Widerstandswert der Leiterzüge, d. h. der Widerstand an der Grenzfläche der beiden Metalle im Kontaktlochbereich ist praktisch gleich Null.

Es wurde festgestellt, daß die an der Aluminiumhilfselektrode vor dem Reinigen der Wafer mittels Kathodenzerstäubung erzeugte Glimmentladung das Restgasspektrum im Argonplasma in einer Weise verändert, wie es mit in der Hochvakuumpraxis üblichen Verfahren nicht möglich ist. Versuche mit einer Meißnerfalle oder einer Kryopumpe, bzw. eine Titanverdampfung, führten nicht zu der gewünschten Verbesserung des Vakuums. Auch Stahlblech als Elektrodenmaterial zeigte den für die Getterung von Restgas gewünschten Effekt nicht. In allen diesen Fällen waren die Kontakte hochohmig. Es wurde auch festgestellt, daß Aluminium als Elektrodenmaterial bei der In-situ-Reinigung von Aluminium- oder Aluminiumkupfer-Kontakten mittels Kathodenzerstäubung offenbar eine besondere Rolle spielt. Es sei jedoch darauf hingewiesen, daß als Elektrodenmaterial auch andere Metalle, welche eine ähnliche Getterwirkung wie Aluminium aufweisen, verwendet werden können. Als solches kommt beispielsweise Titan in Frage.

Gegenüber dem Stand der Technik wird bei dem erfindungsgemäßen Verfahren in der Arbeitskammer ein Plasma erzeugt, welches durch Anlegen einer Spannung an die Aluminiumhilfselektrode und anschließend an den Substrathalter aufgeteilt wird. Während der Zeit, in der die Spannung an die Aluminiumhilfselektrode angelegt ist, wird der Wasserdampfpartialdruck in der Kammer reduziert. Der eigentliche Reinigungsprozeß mittels Kathodenzerstäubung findet dann statt, wenn die Hochfrequenz an den Substrathalter gelegt wird. Durch die zeitliche und räumliche Aufteilung des Plasmas kann die Zeit für die eigentliche In-situ-Reinigung mittels Kathodenzerstäubung beträchtlich reduziert werden, so daß auch Strukturen mit Masken aus temperaturempfindlichen Resistmaterialien in vorteilhafter Weise mit dem beschriebenen Verfahren gereinigt werden können.

## Patentansprüche

1. Verfahren zur Herstellung von Kontakten mit niedrigem Übergangswiderstand zwischen einer ersten und einer zweiten Metallisierung in integrierten Halbleiterschaltungen, bei dem Halbleitersubstrate in einen Substrathalter einer Vakuumkammer gelegt werden, die Kammer evakuiert und ein Edelgas eingeführt wird und die Substrate im Bereich der Kontaktöffnungen und Kanäle durch Anlegen einer Hochfrequenz an den Substrathalter mittels Kathodenzerstäubung gereinigt werden, dadurch gekennzeichnet, daß vor dem Anlegen der Hochfrequenz an den Substrathalter an einer Hilfselektrode, welche aus einem eine Getterwirkung aufweisenden Material besteht und gegen die Wandungen der Kammer elektrisch isoliert ist, ein Gasplasma erzeugt wird.

2. Verfahren nach Anspruch 1, dadurch gekennzeichnet, daß die Kammer (12) in den Hochvakuumbereich evakuiert und Argon bis zu einem Druck von etwa $1,33 \times 10^{-3}$ bis $1,33 \times 10^{-2}$ Millibar zugeführt wird.

3. Verfahren nach Anspruch 1, dadurch gekennzeichnet, daß zur Erzeugung eines Gasplasma eine Gleichspannung oder Hochfrequenz an die Hilfselektrode (20) angelegt wird.

4. Verfahren nach Anspruch 1, dadurch gekennzeichnet, daß eine Hilfselektrode aus Aluminium oder Titan angewendet wird.

5. Verfahren nach einem oder mehreren der Ansprüche 1 bis 4, dadurch gekennzeichnet, daß das Gasplasma für die Dauer von etwa 5 bis 10 Minuten erzeugt wird.

6. Verfahren nach Anspruch 1, dadurch gekennzeichnet, daß zur Reinigung mittels Kathodenzerstäubung für die Dauer von etwa 1/2 bis 1 Minute eine Hochfrequenz an den Substrathalter (18) angelegt wird.

7. Verfahren nach Anspruch 6, dadurch gekennzeichnet, daß die Kathodenzerstäubung mit einer Energiedichte von etwa 0,2 bis 0,3 Watt/cm² durchgeführt wird.

8. Verfahren nach den Ansprüchen 1 bis 7, dadurch gekennzeichnet, daß im Anschluß an die Reinigung mittels Kathodenzerstäubung ohne Unterbrechung des Vakuums der Kammer das Metall für die nächste Metallage aufgedampft wird.

9. Anwendung des Verfahrens nach den Ansprüchen 1 bis 8 zur Reinigung von Halbleitersubstraten mit Masken aus temperaturempfindlichen Resistmaterialien.

10. Vorrichtung zur Durchführung des Verfahrens nach den Ansprüchen 1 bis 8, dadurch gekennzeichnet, daß in einer Arbeitskammer (12) eine Hilfselektrode (20), welche aus einem eine Getterwirkung aufweisenden Material besteht und gegen die Wandungen der Kammer elektrisch isoliert ist, für die Erzeugung eines Gasplasmas vorgesehen und ein elektrisch isolierter Substrathalter (18), an welchem eine Hochfrequenz angelegt wird, für die Aufnahme von Halbleitersubstraten (19) drehbar angeordnet ist.

11. Vorrichtung nach Anspruch 10, dadurch gekennzeichnet, daß ein Anschluß (16) der Arbeitskammer (12) an eine Diffusionspumpe und ein Einlaß (17) für Edelgas vorgesehen sind.

12. Vorrichtung nach Anspruch 10, dadurch gekennzeichnet, daß eine Hochfrequenzdurchführung (21) vorgesehen ist, die die Rotation auf den Substrathalter (18) überträgt und die zum Anlegen einer Hochfrequenz an den Substrathalter dient.

13. Vorrichtung nach Anspruch 10, dadurch gekennzeichnet, daß ein Schieber (14) vorgesehen ist, der in Pfeilrichtung (23) bewegbar ist, um die Arbeitskammer (12) von einer Verdampfkammer (11) abzutrennen.

## Claims

1. Method of making low resistance contacts between a first and a second metallization in integrated semiconductor circuits, where semiconductor substrates are placed into a substrate holder of a vacuum chamber, the chamber is evacuated and a noble gas is introduced, and the substrates in the area of the contact openings and channels are cleaned by cathode sputtering by applying a high frequency to the substrate holder, characterized in that prior to the applying of the high frequency to the substrate holder a gas plasma is generated at an auxiliary electrode consisting of a material with a gettering effect and being electrically insulated against the walls of the chamber.

2. Method as claimed in claim 1, characterized in that the chamber (12) is evacuated down to the high vacuum range, and argon is introduced up to a pressure of approximately $1.33 \times 10^{-3}$ to $1.33 \times 10^{-2}$ millibar.

3. Method as claimed in claim 1, characterized in that for generating a gas plasma a direct voltage or high frequency is applied to the auxiliary electrode (20).

4. Method as claimed in claim 1, characterized in that an auxiliary electrode of aluminum or titanium is used.

5. Method as claimed in any one or several of claims 1 to 4, characterized in that the gas plasma is generated for a period of approx. 5 to 10 minutes.

6. Method as claimed in claim 1, characterized in that for cleaning by means of cathode sputtering a high frequency is applied to the substrate holder (18) for a period of approximately 1/2 to 1 minute.

7. Method as claimed in claim 6, characterized in that the cathode sputtering is implemented with an energy density of approximately 0.2 to 0.3 watt/cm².

8. Method as claimed in claims 1 to 7, characterized in thatsubsequent to the cleaning by means of cathode sputtering the metal for the next metallization level is vapor deposited without an interruption of the chamber vacuum.

9. Using the method as claimed in any one of claims 1 to 8 for cleaning semiconductor substrates with masks of temperature-sensitive materials.

10. Device for carrying out the method as claimed in claims 1 to 8, characterized in that in a working chamber (12) an auxiliary electrode (20) consisting of a material with a gettering effect and being electrically insulated against the walls of the chamber is provided for generating a gas plasma, and that an electrically insulated substrate holder (18) to which a high frequency is applied is rotatably arranged for receiving semiconductor substrates (19).

11. Device as claimed in claim 10, characterized in that a connection (16) of the working chamber (12) to a diffusion pump, and an inlet (17) for noble gas are provided.

12. Device as claimed in claim 10, characterized in that a high frequency conduit (21) is provided which transfers the rotation to the substrate holder (18), and is used for applying a high frequency to the substrate holder.

13. Device as claimed in claim 10, characterized in that a separating valve (14) is provided which is movable in arrow direction (23) to separate the working chamber (12) from an evaporation chamber (11).

## Revendications

1. Procédé pour former des contacts de faible résistance de transition entre une première et une seconde métallisation dans des circuits semiconducteurs intégrés, selon lequel des substrats semi-conducteurs sont disposés dans un support de substrats d'une chambre à vide, la chambre est mise sous vide, un gaz rare est introduit et les substrats sont nettoyés dans la zone des ouvertures de contacts et des canaux par application d'une haute fréquence au support de substrats au moyen d'une pulvérisation cathodique, caractérisé en ce que, avant l'application de la haute fréquence au support de substrats, un plasma gazeux est produit sur une électrode auxiliaire, qui est formée d'un matériau exerçant une action de piège et qui est isolée électriquement des parois de la chambre.

2. Procédé selon la revendication 1, caractérisé en ce que la chambre (12) est amenée dans le domaine du vide poussé et de l'argon est introduit jusqu'à une pression d'environ $1,33 \times 10^{-3}$ à $1,33 \times 10^{-2}$ millibar.

3. Procédé selon la revendication 1, caractérisé en ce que, pour produire un plasma gazeux, une tension continue ou une haute fréquence est appliquée à l'électrode auxiliaire (20).

4. Procédé selon la revendication 1, caractérisé en ce qu'on utilise une électrode auxiliaire en aluminium ou en titane.

5. Procédé selon l'une ou plusieurs des revendications 1 à 4, caractérisé en ce que le plasma gazeux est produit pendant une durée d'environ 5 à 10 minutes.

6. Procédé selon la revendication 1, caractérisé en ce que, pour un nettoyage par pulvérisation cathodique, une haute fréquence est appliquée au support de substrats (18) pendant une durée d'environ 1/2 à 1 minute.

7. Procédé selon la revendication 6, caractérisé en ce que la pulvérisation cathodique est effectuée avec une densité d'énergie d'environ 0,2 à 0,3 Watt/cm$^2$.

8. Procédé selon les revendications 1 à 7, caractérisé en ce que, à la suite du nettoyage par pulvérisation cathodique, le métal pour la couche métallique suivante est vaporisé sans interruption du vide dans la chambre.

9. Utilisation du procédé selon les revendications 1 à 8 pour un nettoyage de substrats semiconducteurs avec des masques en matériaux photosensibles sensibles à la température.

10. Dispositif pour la mise en œuvre du procédé selon les revendications 1 à 8, caractérisé en ce qu'il est prévu dans une chambre de travail (12) une électrode auxiliaire (20), qui se compose d'un matériau exerçant une action de piège et qui est isolée électriquement des parois de la chambre, pour la production d'un plasma gazeux et un support de substrats (18), isolé électriquement et auquel est appliquée une haute fréquence, est disposé de façon tournante pour la réception de substrats semi-conducteurs.

11. Dispositif selon la revendication 10, caractérisé en ce qu'il est prévu une liaison (16) de la chambre de travail (12) avec une pompe à diffusion et une entrée (17) pour un gaz rare.

12. Dispositif selon la revendication 10, caractérisé en ce qu'il est prévu un organe de traversée de haute fréquence (21) qui transmet la rotation au support de substrats (18) et qui sert à appliquer une haute fréquence au support de substrats.

13. Dispositif selon la revendication 10, caractérisé en ce qu'il est prévu une coulisse (14) qui est mobile dans le sens de la flèche (23) pour séparer la chambre de travail (12) d'une chambre de vaporisation (11).

FIG. 1

FIG. 2

1

FIG. 3

FIG.4